# EUROPÄISCHE PATENTSCHRIFT

(11) **EP 1 065 735 B1**
(45) Veröffentlichungstag und Bekanntmachung des Hinweises auf die Patenterteilung: **07.03.2007**
(21) Anmeldenummer: 00113520.1
(22) Anmeldetag: 26.06.2000
(51) Int. Cl.: H01L 41/047

(54) **Piezoaktor mit einer elektrisch leitenden Mehrschichtfolie**
Piezoelectric actuator with a conductive multilayer foil
Actionneur piezoélectrique avec une feuille multicouche conductrice

(30) Priorität: 29.06.1999 DE 19929687
(43) Veröffentlichungstag der Anmeldung: 03.01.2001
(73) Patentinhaber: SIEMENS AKTIENGESELLSCHAFT, 80333 München (DE)
(72) Erfinder: Schuh, Carsten, 85598 Baldham (DE); Lubitz, Karl, 85521 Ottobrunn (DE); Cramer, Dieter, 8042 Graz (AT); Steinkopff, Thorsten, 85614 Eglharting (DE); Hahn, Iris, 85579 Neubiberg (DE); Wolff, Andreas, 81825 München (DE); Scherer, Clemens, 82205 Gilching (DE)

(56) Entgegenhaltungen:
- DE-A- 19 740 570
- DE-C- 19 615 694
- DE-C- 19 646 676
- DE-C- 19 715 488
- PATENT ABSTRACTS OF JAPAN Bd. 0151, Nr. 14 (E-1047), 19. März 1991 (1991-03-19) & JP 3 004576 A (FUJI ELECTRIC CO LTD), 10. Januar 1991 (1991-01-10)

## Beschreibung

Die Erfindung betrifft einen Piezoaktor mit einem Aktorkörper und einer elektrisch leitenden Mehrschichtfolie zu einer Steuerung einer Expansion und einer Kontraktion des Aktorkörpers, wobei die Mehrschichtfolie mindestens eine Trägerschicht, mindestens eine elektrische Leitungsschicht und mindestens ein starres elektrisches Anschlußelement aufweist. Ein derartiger Piezoaktor ist beispielsweise aus DE 197 15 488 C1 bekannt.

Ein Piezoaktor ist beispielsweise aus mehreren zu einem stapelförmigen Aktorkörper angeordneten Piezoelementen aufgebaut. Jedes Piezoelement besteht aus einer Piezokeramikschicht, die beiderseits mit einer metallischen Elektrode versehen ist. Wird an diese Elektroden, die auch als Innenelektroden bezeichnet werden, eine elektrische Spannung angelegt, so ändert sich eine Oberflächenladung der Piezokeramikschicht. Auf diese Änderung der Oberflächenladung reagiert die Piezokeramikschicht mit einer Gitterverzerrung (Piezoeffekt). Als Folge der Gitterverzerrung expandiert und kontrahiert das Piezoelement und damit der Aktorkörper in einer Richtung, die durch die Anordnung der Piezokeramikschicht und der Elektroden eines Piezoelements bestimmt ist. Entsprechend einem Ausmaß der Expansion und Kontraktion kommt es zu einer nutzbaren Änderung einer Ausdehnung des stapelförmigen Aktorkörpers.

Aus DE 197 15 488 C1 ist ein derartiger Piezoaktor bekannt. Der Piezoaktor verfügt über einen Aktorkörper in monolithischer Vielschichtbauweise. Der Aktorkörper umfaßt zumindest einen Stapel alternierender Elektroden und Piezokeramikschichten. Eine Elektrodenschicht dient jeder benachbarten Piezokeramikschicht als Elektrode (Innenelektrode). Dazu erfolgt eine elektrische Kontaktierung der Elektrodenschichten in einer alternierenden Polarität. Die alternierende Polarität wird mit Hilfe zweier Außenelektroden erreicht. Eine Außenelektrode besteht aus einem Metallisierungsstreifen und einer elektrisch leitfähigen Mehrschichtfolie. Ein Metallisierungsstreifen ist an einer seitlichen Oberfläche des Aktorkörpers angebracht. Er erstreckt sich dabei über eine Höhe, die sich aus übereinander gestapelten, elektrisch aktiven Schichten des Aktorkörpers ergibt. Ein Metallisierungsstreifen ist mit jeder zweiten Elektrodenschicht elektrisch leitend verbunden und gegen jede dazwischenliegende erste Elektrodenschicht elektrisch isoliert. Dagegen ist der zweite Metallisierungsstreifen gegen jede zweite Elektrodenschicht isoliert und mit jeder ersten Elektrodenschicht elektrisch leitend verbunden. Eine elektrische Isolierung einer Elektrodenschicht gegenüber einem Metallisierungsstreifen gelingt mit Hilfe einer Aussparung in der Elektrodenschicht. Dabei ist die Elektrodenschicht nicht bis an die seitliche Oberfläche des Aktorkörpers geführt, an der der Metallisierungsstreifen angebracht ist. Einen derartigen Bereich des Aktorkörpers bezeichnet man als piezoelektrisch inaktiven Bereich des Aktorkörpers.

Um die elektrische Kontaktierung jeder einzelnen Elektrodenschicht sicherzustellen, erfolgt in dem bekannten Piezoaktor eine Spannungszuführung an einen Metallisierungsstreifen über eine streifenförmige, elektrisch leitfähige Mehrschichtfolie in Form einer mit Kupfer kaschierten Kunststoffolie. Die Mehrschichtfolie ist dabei über eine Kante an einem Metallisierungsstreifen angelötet. Die Mehrschichtfolie erstreckt sich über die gesamte Höhe der elektrisch aktiven Schichten des Aktorkörpers. Eine vom Aktorkörper wegweisende Außenkante der Mehrschichtfolie ist mit einem starren elektrischen Anschlußelement verbunden. Mit Hilfe der Mehrschichtfolie wird ein eventuell auftretender Riß in einem Metallisierungsstreifen elektrisch überbrückt. Dadurch zeigt der Piezoaktor eine hohe Zyklenzahl und damit eine lange Lebensdauer. Ein Zyklus umfaßt eine einmalige Expansion und Kontraktion des Piezoaktors bzw. des Aktorkörpers.

Um Rissausbreitung in einer elektrisch leitenden Mehrschichtfolie während der Expansion und Kontraktion des Aktorkörpers zu unterbinden, sind gemäß DE 197 40 570 A1 Ausschnitte in der Mehrschichtfolie vorhanden. Diese Ausschnitte können kreisförmig, ellipsenförmig oder schlitzförmig sein.

Aufgabe der Erfindung ist es, einen Piezoaktor anzugeben, der gegenüber einem bekannten Piezoaktor eine verbesserte elektrische Kontaktierung und damit eine höhere Zyklenzahl und längere Lebensdauer aufweist.

Zur Lösung der Aufgabe wird ein Piezoaktor mit einem Aktorkörper und einer elektrisch leitfähigen Mehrschichtfolie zu einer Steuerung einer Expansion und einer Kontraktion des Aktorkörpers angegeben, wobei die Mehrschichtfolie mindestens eine Trägerschicht, mindestens eine elektrische Leitungsschicht und mindestens ein starres elektrisches Anschlußelement aufweist. Die Leitungsschicht weist eine Vielzahl von Ausnehmungen auf. Die Mehrschichtfolie ist dadurch gekennzeichnet, daß die Ausnehmungen parallel zueinander angeordnete Spalte sind, die im Wesentlichen senkrecht zu einer Richtung der Expansion und Kontraktion des Aktorkörpers angeordnet sind. Die Mehrschichtfolie kann, wie oben beschrieben, indirekt über einen Metallisierungsstreifen mit den Innenelektroden des Aktorkörpers verbunden sein. Die Mehrschichtfolie kann aber auch direkt an den Innenelektroden angeordnet sein. Beispielsweise ist die Mehrschichtfolie an die Innenelektroden angelötet. Das elektrische Anschlußelement dient einer elektrischen Kontaktierung der elektrischen Leitungsschicht der Mehrschichtfolie. Es ist beispielsweise an einer vom Aktorkörper wegweisenden Kante der Mehrschichtfolie so angelötet, daß die Mehrschichtfolie von dem Anschlußelement überragt wird. Das Anschlußelement kann auch direkt auf eine Fläche der Leitungsschicht angebracht sein.

Aufgrund der Expansion und Kontraktion des Aktorkörpers treten in einer Außenelektrode, die in Richtung der Expansion und Kontraktion am Aktorkörper befestigt ist, mechanische Spannungen auf. Diese mechanischen Spannungen können zu einem Riß in der Außenelektrode führen. Ein Riß kann dabei nicht nur in einem Metallisierungsstreifen auftreten. Ein Riß kann sich auch in einer elektrisch leitfähigen Mehrschichtfolie bilden bzw. sich ausgehend vom Metallisierungsstreifen in die Mehrschichtfolie fortsetzen. Der Riß kann sich im Verlauf des Betriebs des Piezoaktors weiter ausdehnen und zu einem Ausfall des piezoelektrischen Aktors führen. Also Folge davon kann eine gesamte Außenelektrode mit Metallisierungsstreifen und Mehrschichtfolie durchtrennt werden und so der Piezoaktor ausfallen.

Die grundlegende Idee der Erfindung besteht darin, die mechanischen Spannungen in einer elektrisch leitfähigen Mehrschichtfolie während des Betriebs des Piezoaktors zu minimieren. Diese mechanischen Spannungen sind beispielsweise dann besonders groß, wenn im piezoelektrisch inaktiven Bereich des Aktorkörpers ein Riß durch eine Polarisierung des Piezoaktors entstanden ist (Polungsriß). Bei der Expansion und der Kontraktion findet bei einen solchen Riß eine relativ große Änderung eines Ausmaßes des Aktorkörpers statt. Durch diese große Änderung treten große mechanische Spannungen in der Mehrschichtfolie auf, insbesondere dann, wenn die Mehrschichtfolie mit einem starren Anschlußelement fest verbunden ist. Diese Spannungen werden durch geeignete Maßnahmen reduziert.

Eine elektrische Leitungsschicht der Mehrschichtfolie ist beispielsweise eine Metallschicht. Eine Metallschicht ist im allgemeinen wenig flexibel und somit kaum in der Lage, auftretende mechanische Spannungen abzubauen. Die Erfindung zielt deshalb insbesondere auf eine Erhöhung der Flexibilität der elektrischen Leitungsschicht ab.

Die Erhöhung der Flexibilität wird in erster Linie durch Einbringen einer Aussparung bzw. einer Ausdünnung in die Leitungsschicht. Die Leitungsschicht weist somit Ausschnitte.

Diese Ausschnitte sind spaltförmig. Ein solcher Spalt kann die Leitungsschicht lateral teilweise durchdringen. In dieser Form ist ein Spalt ein Schlitz oder Graben der Leitungsschicht. Der Spalt kann die Leitungsschicht aber auch vollständig durchdringen. Wenn ein Spalt die Leitungsschicht in Dickenrichtung vollständig durchdringt, weist die Leitungsschicht elektrisch leitfähige Stege auf. Zwei Stege sind durch einen Spalt voneinander getrennt. Viele parallel zueinander angeordnete derartige Spalte führen zu einer Vielzahl zueinander paralleler Stege. Diese Vielzahl von Spalten ist nahezu senkrecht zur Richtung der Expansion und Kontraktion des Aktorkörpers angeordnet.

In einer besonderen Ausgestaltung weist die Leitungsschicht mindestens ein Metall auf. Ein Metall ist insbesondere aus der Gruppe Aluminium, Beryllium, Kobalt, Eisen, Kupfer und Nickel ausgewählt. Es wird insbesondere eine Kupfer-, Nickel und/oder Aluminiumbasislegierung verwendet. Verschiedene Stähle sind ebenfalls denkbar. Von besonderem Vorteil ist eine Kupfer-Beryllium und eine Nickel-Beryllium-Legierung. Diese Legierungen zeichnen sich durch eine hohe Ermüdungsfestigkeit und damit durch eine hohe mechanische Langzeitstabilität aus.

Als Material der Leitungsschicht sind neben Metallen nichtmetallische Leiter wie beispielsweise organische Leitermaterialien denkbar.

An die Trägerschicht sind zwei Anforderungen geknüpft: Sie soll die Leitungsschicht stabilisieren und gleichzeitig eine hohe Flexibilität der gesamten Mehrschichtfolie gewährleisten. Dazu verfügt die Trägerschicht in einer besonderen Ausgestaltung über ein Verformungsmaterial. Dieses Verformungsmaterial zeichnet sich beispielsweise durch einen niedrigen Elastizitätsmodul aus. Das Verformungsmaterial der Trägerschicht ist beispielsweise ein Elastomer. Möglich ist auch, daß die Trägerschicht ganz aus einem Elastomer besteht.

In einer besonderen Ausgestaltung der Erfindung weist die Trägerschicht zur Erhöhung einer Flexibilität der Mehrschichtfolie mindestens einen Ausschnitt auf. Der Effekt eines derartigen Ausschnitts ist oben beschrieben.

Vorzugsweise besteht die Trägerschicht aus einem elektrisch isolierenden Material. Das Material der Trägerschicht und das Material der Leitungsschicht weisen vorteilhaft ein ähnliches Temperaturausdehnungsverhalten auf.

In einer besonderen Ausgestaltung der Erfindung weist die Mehrschichtfolie eine Trägerschicht aus Polyimid auf. Dieses Material zeichnet sich durch einen niedrigen Elastizitätsmodul in einem weiten Temperaturbereich aus. Beispielsweise wird ein Piezoaktor in einem Dieseleinspritzsystem verwendet wird. Dabei tritt eine Temperatur aus einem Temperaturbereich von - 40°C bis + 150°C auf. In diesen Temperaturbereich hat die Trägerschicht eine hohe Stabilität und gleichzeitig eine hohe Flexibilität.

Als weiteres Elastomer unter vielen denkbaren sei an dieser Stelle noch Polyurethan erwähnt.

Die Trägerschicht der Mehrschichtfolie muß nicht notwendigerweise elektrisch isolierend sein. Sie kann auch elektrisch leitfähig sein.

Es sind verschiedenste Designvariationen der Mehrschichtfolie mit den spaltförmigen Ausschnitten denkbar. Diese Designvariationen können für ein bestimmtes Material der Leitungsschicht und/oder Trägerschicht unterschiedlich ausfallen und so zu einer Minimierung mechanischer Spannungen während des Betriebs und auch während der Polarisierung des Piezoaktors führen. Diese Designvariationen betreffen beispielsweise die Form und Größe der Ausschnitte der Leitungsschicht. Ziel kann dabei sein, daß eine Kerbempfindlichkeit der Leitungsschicht minimiert wird. Eine verminderte Kerbempfindlichkeit der Leitungsschicht an einem Loch führt dazu, daß eine Rißbildung in der Leitungsschicht am Loch unterbleibt bzw. nur erschwert statt finden kann. Dazu wird beispielsweise ein Ende eines Ausschnitts in Form eines Schlitzes abgerundet. Es kann auch an dem Ausschnitt eine mechanische Spannung in der Leitungsschicht künstlich aufgebaut werden, die einer mechanischen Spannung, die im Betrieb des Piezoaktors auftritt, entgegenwirkt. Durch "Aufdornen" wird beispielsweise die Leitungsschicht am Ausschnitt unter eine Druckspannung gesetzt, die eine Zugspannung in der Leitungsschicht während des Betriebs des Piezoaktors vermindert. Beim "Aufdornen" wird in einen Ausschnitt der Leitungsschicht ein Werkstück gesteckt, das einen etwas größeren Durchmesser aufweist als der Ausschnitt selbst. Das Einbringen einer künstlichen Spannung erfolgt bei einem Schitz beispielsweise an den Enden des Schlitzes.

Eine Mehrschichtfolie kann aus mehreren Träger- und/oder Leitungsschichten bestehen. Beispielsweise ist eine Leitungsschicht zwischen zwei Trägerschichten oder eine Trägerschicht zwischen zwei Leitungsschichten angeordnet. Denkbar ist beispielsweise eine Mehrschichtfolie mit einer Schichtfolge Kupfer-Polyimid-Kupfer oder Polyimid-Kupfer-Polyimid.

Zusammenfassend ergeben sich mit der vorliegenden Erfindung folgende Vorteile:
- Die spaltförmigen Ausschnitte in der Leitungsschicht der elektrisch leitfähigen Mehrschichtfolie führen dazu, daß mechanische Spannungen in der Leitungsschicht reduziert sind. Eine Wahrscheinlichkeit für das Auftreten eines Risses in der Leitungsschicht ist verringert.
- Wenn in der Leitungsschicht ein Riß auftritt, wird eine Ausbreitung des Risses durch die Ausschnitte erschwert bzw. verhindert.
- Die Trägerschicht reduziert Vibrationen, die während des Betriebs des Piezoaktors auftreten und zu rißbildenden mechanischen Spannungen führen können.
- Während des Betriebs des Piezoaktors bleiben die Innenelektroden des Aktorkörpers elektrisch kontaktiert. Es resultiert eine sehr hohe Zyklenzahl und damit Lebensdauer des Piezoaktors.
- Zur Strukturierung der Leitungsschicht können gängige Verfahren verwendet werden, die in der Dünnschichttechnik eingesetzt werden.

Anhand mehrerer Ausführungsbeispiele und der dazugehörigen Zeichnungen wird im folgenden eine Mehrschichtfolie zur Steuerung einer Expansion und Kontraktion eines Piezoaktors vorgestellt. Die Figuren sind schematisch und stellen keine maßstabsgetreuen Abbildungen der bezeichneten Gegenstände dar.
- Figur 1a: zeigt einen Piezoaktor bestehend aus einem Aktorkörper und zwei Mehrschichtfolien mit starren elektrischen Anschlußelementen von der Seite.
- Figur 1b: zeigt einen Querschnitt einer Mehrschichtfolie.
- Figuren 2a bis 2c: zeigen verschiedene Ausführungsformen der elektrischen Leitungsschicht einer Mehrschichtfolie.
- Figuren 3a und 3c: zeigen jeweils einen Ausschnitt der Mehrschichtfolie an den Löchern von oben.
- Figur 4: zeigt ein Verfahren zur Herstellung einer Mehrschichtfolie.

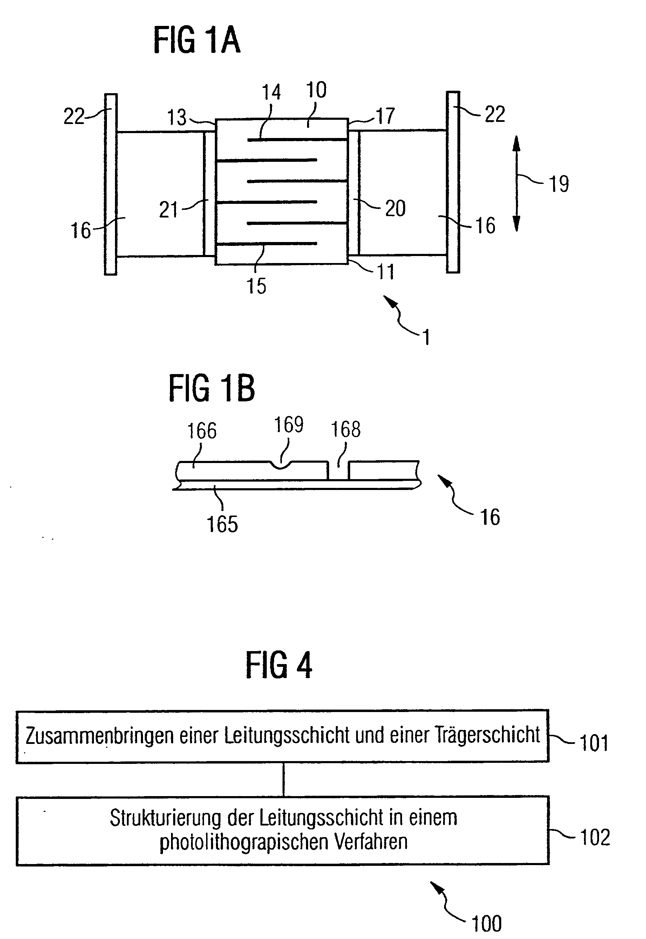

Der Piezoaktor 1 nach Figur 1a besteht aus einem Aktorkörper 11 in Form eines Stapels von Piezokeramikschichten 10 und dazwischen angeordneten Elektrodenschichten als Innenelektroden 14 und 15. Eine Piezokeramikschicht 10 besteht aus einem PZT-Material. Das Material einer Innenelektrode 14 und 15 umfaßt eine silberhaltige Einbrennpaste.

An den beiden seitlichen Oberflächen 12 und 13 des Aktorkörpers 11, parallel zu der Richtung 19, in der die Expansion 17 und die Kontraktion 18 des Aktorkörpers 11 stattfindet, ist jeweils ein Metallisierungsstreifen 20 bzw. 21 angebracht. Ein Metallisierungsstreifen 20 bzw. 21 besteht aus einer eingebrannten Silberpaste. Jeweils eine elektrisch leitfähige Mehrschichtfolie 16 ist über ein Lot mit dem Metallisierungsstreifen 20 oder 21 der Oberfläche des Aktorkörpers 11 mechanisch und elektrisch leitend verbunden. Die Verbindung erfolgt jeweils über die Höhe der zu kontaktierenden Elektrodenschichten. Die Mehrschichtfolie 16 besteht aus einer Trägerschicht 165 aus Polyimid und einer elektrischen Leitungsschicht 166 aus Kupfer (siehe Figur 1b). An jede Mehrschichtfolie 16 ist ein starres elektrisches Anschlußelement 22 angelötet. Ein Anschlußelement 22 ist dabei an einer vom Aktorkörper 11 wegweisenden Kante der Mehrschichtfolie 16 angebracht und überragt sowohl den Aktorkörper 11 als auch die Mehrschichtfolie 16.

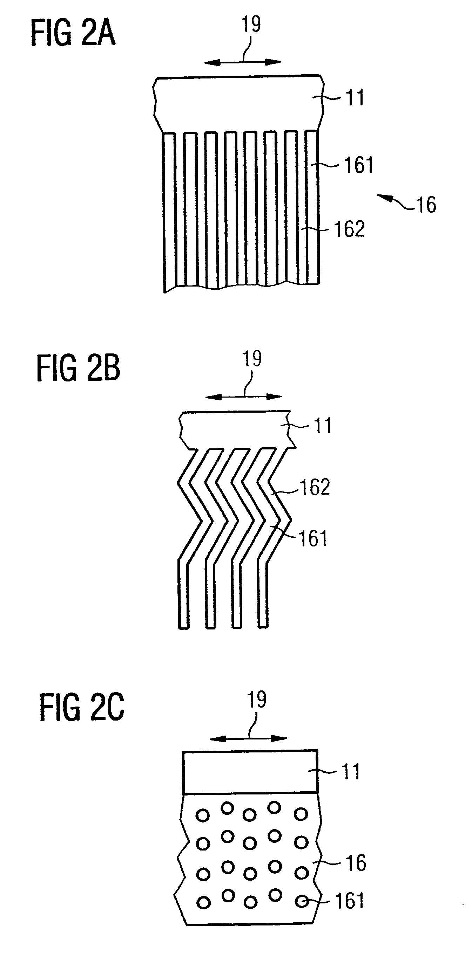

Figur 2a zeigt, wie die Leitungsschicht 166 der Mehrschichtfolie 16 strukturiert ist. Dabei sind die Löcher 161 in Form einer Vielzahl zueinander paralleler Spalte ausgebildet. Es resultieren eine Vielzahl zueinander paralleler Stege 162, die senkrecht zur Richtung 19 der Expansion 17 und Kontraktion 18 des Aktorkörpers 11 angeordnet sind.

In Figur 2b zeichnet sich die Anordnung der Spalte 161 dadurch aus, daß in der Summe ein Grätenmuster entsteht.

Figur 2c zeigt eine Ausführungsform gemäß der DE 197 40 570 A1, in der eine Vielzahl runder Löcher 161 in die Leitungsschicht 166 eingebracht ist.

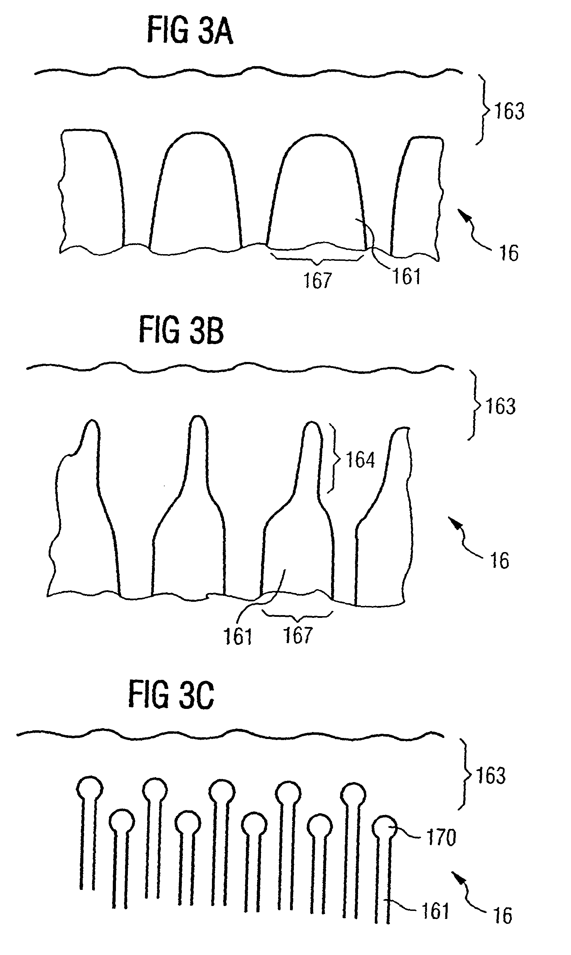

Ein Spalt 161 ist im Kontaktierungsbereich 163 nicht bis an den Rand der Leitungsschicht 166 geführt, über den die Leitungsschicht 166 mit den Innenelektroden bzw. einem Metallisierungsstreifen 20 bzw. 21 verbunden ist (Figuren 3a bis 3c). Die Ausgestaltung eines Spalts 161 an einer solchen Stelle kann unterschiedlich sein. Nach Figur 3a nimmt ein Durchmesser 167 des Spalts 161 kontinuierlich bis zu einem bestimmten Endwert ab. In Figur 3b weist der Spalt 161 im Kontaktierungsbereich 163 über eine bestimmte Länge 164 einen verkleinerten Durchmesser 167 auf. In der Ausführungsform nach Figur 3c ist ein Spalt 161 im Kontaktierungsbereich 163 gerundet. Durch eine Rundung 170 wird die Kerbempfindlichkeit der Leitungsschicht 161 herabgesetzt.

Weitere Ausführungsformen zeichnen sich dadurch aus, daß in dem Bereich, in dem das starre elektrische Anschlußelement 22 mit der Leitungsschicht 166 fest verbunden ist, die Leitungsschicht 166 diese Löcher 161 zur Spannungsminimierung aufweist.

Weitere Ausführungsformen ergeben sich dadurch, daß die spaltförmigen Ausschnitte durchgängig (168) und/oder Sacklöcher 169 sind. Ein Spalt in Form eines Sacklochs ist ein Graben.

Jede dieser Ausführungsformen hat zum Ziel, die mechanischen Spannungen in der Mehrschichtfolie 16 auf ein Minimum zu reduzieren bzw. die mechanischen Spannungen ausgehend vom Aktorkörper 11 bis hin zum starren elektrischen Anschlußelement 22 abzubauen. Die Ausführungsformen können sich dabei materialbezogen unterscheiden. Materialbezogen bedeutet, daß hier sowohl das Material der Trägerschicht 165 als auch das Material der Leitungsschicht 166 eine Rolle spielt. Ebenso spielt hier die Größe der Ausschnitte 161 eine Rolle.

## Patentansprüche

1. Piezoaktor (1) mit einem Aktorkörper (11) und einer elektrisch leitenden Mehrschichtfolie (16) zu einer Steuerung einer Expansion (17) und einer Kontraktion (18) des Aktorkörpers (11), wobei die Mehrschichtfolie (16) mindestens eine Trägerschicht (165), mindestens eine elektrische Leitungsschicht (166) und mindestens ein starres elektrisches Anschlußelement (22) aufweist und die Leitungsschicht einer Vielzahl von Ausschnitten aufweist,
**dadurch gekennzeichnet, daß**
die Ausschnitte parallel zueinander angeordnete Spalte sind und die Spalte im Wesentlichen senkrecht zu einer Richtung der Expansion und Kontraktion des Aktorkörpers angeordnet sind.

2. Piezoaktor nach Anspruch 1, wobei die Leitungsschicht mindestens ein aus der Gruppe Aluminium, Beryllium, Cobalt, Eisen, Kupfer und Nickel ausgewähltes Metall aufweist.

3. Piezoaktor nach Anspruch 1 oder 2, wobei die Trägerschicht ein Verformungsmaterial aufweist.

4. Piezoaktor nach einem der Ansprüche 1 bis 3, wobei die Trägerschicht (165) mindestens einen Ausschnitt aufweist.

5. Piezoaktor nach Anspruch 4, wobei der Ausschnitt der Trägerschicht ein durchgängiges Loch ist.

6. Piezoaktor nach einem der Ansprüche 1 bis 5, wobei die Trägerschicht (165) ein elektrisch isolierendes Material aufweist.

7. Piezoaktor nach Anspruch 6, wobei das elektrisch isolierende Material der Trägerschicht (165) Polyimid ist.

## Claims

1. Piezoelectric actuator (1) including an actuator body (11) and an electrically conductive multilayer foil (16) for controlling an expansion (17) and a contraction (18) of the actuator body (11), wherein the multilayer foil (16) features at least one carrier layer (165), at least one electrical conduction layer (166) and at least one rigid electrical connection element (22), and the conduction layer features a multiplicity of cut-outs,
**characterised in that**
the cut-outs are slots which are arranged in parallel with each other and the slots are arranged essentially perpendicularly relative to a direction of expansion and contraction of the actuator body.

2. Piezoelectric actuator according to claim 1, wherein the conduction layer features at least one metal which is selected from the group comprising aluminium, beryllium, cobalt, iron, copper and nickel.

3. Piezoelectric actuator according to claim 1 or 2, wherein the carrier layer features a distortion material.

4. Piezoelectric actuator according to one of the claims 1 to 3, wherein the carrier layer (165) features at least one cut-out.

5. Piezoelectric actuator according to claim 4, wherein the cut-out of the carrier layer is a completely penetrating hole.

6. Piezoelectric actuator according to one of the claims 1 to 5, wherein the carrier layer (165) features an electrically isolating material.

7. Piezoelectric actuator according to claim 6, wherein the electrically isolating material of the carrier layer (165) is polyimide.

## Revendications

1. Actionneur piézo-électrique (1) comprenant un corps d'actionneur (11) et une feuille multicouche (16) électroconductrice pour la commande d'une expansion (17) et d'une contraction (18) du corps d'actionneur (11), la feuille multicouche (16) contenant au moins une couche de support (165), au moins une couche de conductivité électrique (166) et au moins un élément rigide de connexion électrique (22), la couche de conductivité contenant une pluralité d'encoches, **caractérisé en ce que** les encoches comprennent des fentes disposées en parallèle et essentiellement orthogonalement par rapport à une direction d'expansion et de contraction du corps d'actionneur.

2. Actionneur piézo-électrique selon la revendication 1, dans lequel la couche de conductivité contient au moins un métal choisi dans le groupe constitué par l'aluminium, le béryllium, le cobalt, le fer, le cuivre et le nickel.

3. Actionneur piézo-électrique selon la revendication 1 ou 2, dans lequel la couche de support comprend un matériau de déformation.

4. Actionneur piézo-électrique selon l'une des revendications 1 à 3, dans lequel la couche de support (165) comprend au moins une encoche.

5. Actionneur piézo-électrique selon la revendication 4, dans lequel l'encoche est un trou traversant.

6. Actionneur piézo-électrique selon l'une des revendications 1 à 5, dans lequel la couche de support (165) contient une matière électriquement isolante.

7. Actionneur piézo-électrique selon la revendication 6, dans lequel la matière électriquement isolante de la couche de support (165) est un polyimide.
